## Europäisches Patentamt

## European Patent Office

## Office européen des brevets

(19)

(11) Veröffentlichungsnummer: **0 058 835**
**B1**

# (12) EUROPÄISCHE PATENTSCHRIFT

(45) Veröffentlichungstag der Patentschrift:
**23.04.86**

(21) Anmeldenummer: **82100578.2**

(22) Anmeldetag: **28.01.82**

(51) Int. Cl.⁴: **H 01 L 23/48,** H 01 L 21/60,
G 01 K 7/22

(54) **Halbleitervorrichtung und Verfahren zu ihrer Herstellung.**

(30) Priorität: **20.02.81 DE 3106354**

(43) Veröffentlichungstag der Anmeldung:
**01.09.82 Patentblatt 82/35**

(45) Bekanntmachung des Hinweises auf die Patenterteilung:
**23.04.86 Patentblatt 86/17**

(84) Benannte Vertragsstaaten:
**FR GB IT**

(56) Entgegenhaltungen:
**DE - A - 2 148 658**
**DE - B - 1 208 823**
**DE - B - 1 514 886**
**DE - B - 2 407 374**
**US - A - 3 407 341**

(73) Patentinhaber: **TEXAS INSTRUMENTS DEUTSCHLAND GMBH, Haggertystrasse 1, D-8050 Freising (DE)**

(72) Erfinder: **Vilimek, Vaclav F., Meisenstrasse 1, D-8311 Viecht (DE)**

(74) Vertreter: **Leiser, Gottfried, Dipl.-Ing. et al, Patentanwälte Prinz, Bunke & Partner Ernsberger Strasse 19, D-8000 München 60 (DE)**

EP 0 058 835 B1

## Beschreibung

Die Erfindung bezieht sich auf eine Halbleitervorrichtung gemäss dem Oberbegriff des Patentanspruchs 1 sowie auf ein Verfahren zu ihrer Herstellung. Eine derartige Halbleitervorrichtung ist aus der DE-B-24 07 374 bekannt.

Eine solche Halbleitervorrichtung wird insbesondere als Temperatursensor eingesetzt. Bei einem solchen Temperatursensor wird die Tatsache ausgenutzt, dass sich der Widerstand des Halbleiterkörpers in Abhängigkeit von der Temperatur ändert. Diese Widerstandsänderung kann zur Erzielung einer Strom- oder Spannungsänderung ausgenutzt werden, die dann einen gewünschten temperaturabhängigen Steuervorgang bewirkt. Der Widerstandwert, den der Temperatursensor bei einer bestimmten Solltemperatur hat, muss möglichst genau einem jeweils vorgegebenen Sollwert entsprechen, damit der Temperatursensor von Anwendern universell eingesetzt werden kann und beispielsweise bei einem erforderlich werdenden Austausch kein besonderer Eichvorgang durchgeführt werden muss.

Es erwies sich als schwierig, Temperatursensoren wirtschaftlich herzustellen, die bei einer gegebenen Solltemperatur einen bestimmten Widerstandswert hatten. Es ist üblich, solche Temperatursensoren in grossen Stückzahlen herzustellen, wobei als Ausgangsmaterial Halbleiterscheiben verwendet wurden, auf denen mehr als 10.000 Sensoren gleichzeitig gebildet wurden. Die einzelnen Sensoren wurden dann durch Zerbrechen der Halbleiterscheibe voneinander getrennt, auf einem Sockel angebracht und mit äusseren Anschlüssen versehen. Im Anschluss daran wurden die Widerstandswerte der fertigen Sensoren gemessen, und entsprechend den ermittelten Werten wurden die Sensoren sortiert. Da der spezifische Widerstand der Halbleiterscheiben von Scheibe zu Scheibe verschieden ist und sogar auf einer einzigen Scheibe in verschiedenen Bereichen unterschiedlich sein kann, war es bisher kaum möglich, die Sensoren so herzustellen, dass sie alle bei einer bestimmten Solltemperatur einen vorgegebenen Widerstandswert von beispielsweise 1000 Ohm mit einer Genauigkeit von 1% haben. Nur durch das bereits erwähnte einzelne Messen der Sensoren können diejenigen Sensoren ausgewählt werden, die den Genauigkeitsanforderungen entsprechen. Dies führt zu einer geringen Ausbeute an Temperatursensoren mit der höchsten Genauigkeitsklasse, und ausserdem ist das einzelne Messen der Widerstandswerte aufwendig und führt zu hohen Kosten.

Der Erfindung liegt die Aufgabe zugrunde, eine Halbleitervorrichtung der eingangs geschilderten Art zu schaffen, die sich ohne grossen Aufwand mit grosser Genauigkeit herstellen lässt; ferner soll ein Verfahren zur Herstellung einer solchen Halbleitervorrichtung geschaffen werden.

Zur Lösung dieser Aufgabe enthält die erfindungsgemässe Halbleitervorrichtung die im Kennzeichen des Patentanspruchs 1 angegebenen Merkmale. Bei dieser Halbleitervorrichtung wird die Tatsache ausgenützt, dass bei gegebenem spezifischem Widerstand und bei einer bestimmten Temperatur der Widerstand zwischen zwei Elektroden an einem Halbleiterkörper ausschliesslich von den Elektroden-Kontaktquerschnitten abhängt, falls die Querschnittsabmessungen klein gegen die Dicke des Halbleiterkörpers sind. Da bei der erfindungsgemässen Vorrichtung am Halbleiterkörper mehr als zwei Elektroden mit unterschiedlichen Elektroden-Kontaktquerschnitten angebracht sind, können die äusseren Anschlüsse an zwei entsprechend dem gewünschten Widerstand ausgewählten Elektroden angebracht werden. Die Ausbeute an Halbleitervorrichtungen, die nach dem Anbringen der äusseren Anschlüsse den gewünschten Widerstandswert haben, kann auf diese Weise ganz beträchtlich vergrössert werden.

Vorteilhafte Weiterbildungen der Erfindung sind in den Unteransprüchen gekennzeichnet. Ein bevorzugtes Herstellungsverfahren für die erfindungsgemässe Halbleitervorrichtung ist im Patentanspruch 8 angegeben.

Die Erfindung wird nun anhand der Zeichnung beispielshalber erläutert. Es zeigen:

Fig. 1 eine Draufsicht auf eine nach der Erfindung ausgebildete Halbleitervorrichtung und

Fig. 2 einen Schnitt längs der Linie A–A von Fig. 1.

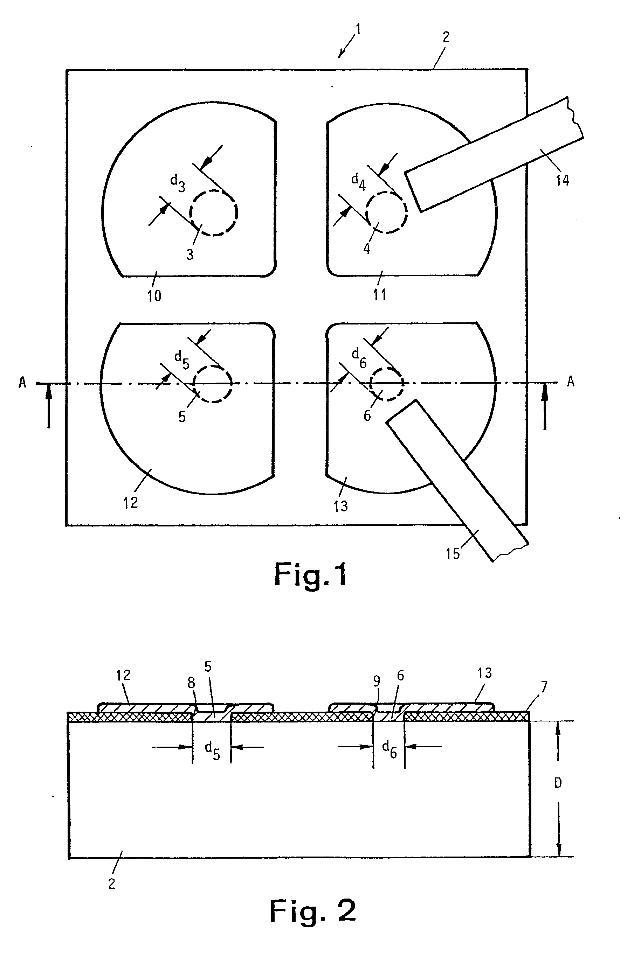

Die in Fig. 1 dargestellte Halbleitervorrichtung ist ein Temperatursensor 1 mit einem Halbleiterkörper 2, auf dessen oberer Fläche vier ohmsche Elektroden 3, 4, 5, 6 angebracht sind. Die Anschlusskontakte 3 bis 6 sind kreisförmig und haben unterschiedliche Durchmesser $d_3$, $d_4$, $d_5$ und $d_6$. Nach Fig. 2 befinden sich die Elektroden 3 bis 6 in kreisförmigen Löchern einer auf der oberen Fläche des Halbleiterkörpers 2 angebrachten Isolierschicht 7. In Fig. 2 sind nur das Loch 8 der Elektrode 5 und das Loch 9 der Elektrode 6 zu erkennen.

Wie die Fig. 1 und 2 zeigen, sind die Elektroden 3 bis 6 auf der Oberfläche der Isolierschicht 7 erweitert, so dass Kontaktierungsflächen 10 bis 13 entstehen, von denen in Fig. 2 die Kontaktierungsflächen 12 und 13 dargestellt sind. Diese Kontaktierungsflächen 10 bis 13 dienen dazu, die Verbindung zwischen ausgewählten Elektroden und den äusseren Anschlüssen herzustellen. In dem in Fig. 1 dargestellten Beispiel ist der äussere Anschluss 14 mit der Kontaktierungsfläche 11 beispielsweise durch Schweissen verbunden, und in gleicher Weise ist der äussere Anschluss 15 mit der Kontaktierungsfläche 13 verbunden. Auf diese Weise hat der in Fig. 1 dargestellte Temperatursensor 1 den zwischen den Elektroden 4 und 6 auftretenden Widerstandwert.

Wenn bei dem in der Zeichnung dargestellten Temperatursensor 1 die Dicke D des Halbleiterkörpers 2 gross gegen die Durchmesser $d_3$, $d_4$, $d_5$ und $d_6$ der Elektroden 3, 4, 5 und 6 ist, hängt der zwischen zwei Elektroden messbare Widerstand bei gegebenem spezifischem Widerstand des Halbleitermaterials und bei einer bestimmten Temperatur ausschliesslich vom Durchmesser der Elektroden ab. Solange die Durchmesseränderung nicht grösser als 5% ist, gilt mit guter Genauigkeit, dass die eintretende Widerstandsänderung einer Durchmesseränderung umgekehrt proportional ist. Diese Tatsache wird bei der Herstellung des Temperatursensors 1 ausgenutzt. Diese Genauigkeit wird eingehalten, wenn der Abstand der Elektroden vom Rand des Halbleiterkörpers nicht zu klein ist.

Bei der Herstellung des Temperatursensors 1 wird auf einer Fläche des Halbleiterkörpers 2, der Teil einer Halbleiterscheibe mit der Dicke D von etwa 250 µm und einem Durchmesser von etwa 7,5 cm sein kann, eine Isolierschicht 7, beispielsweise aus Siliciumdioxid, gebildet. In der Isolierschicht werden dann vier Löcher in der in Fig. 1 dargestellten Anordnung für jeweils einen Temperaturfühler geöffnet, in denen der Halbleiterkörper 2 freiliegt. Die Löcher haben dabei in dieser Vierergruppe unterschiedliche Durchmesser, beispielsweise 48,2 µm, 49,6 µm, 50,8 µm und 52,1 µm; in der Praxis können auf einer Halbleiterscheibe gleichzeitig Löchergruppen für eine sehr grosse Anzahl, beispielsweise 17.000 Temperatursensoren, gebildet werden.

Auf die mit Löchern versehene Isolierschicht 7 wird dann eine Metallschicht aufgedampft, die zur Bildung der Elektroden durch die Löcher mit dem Halbleiterkörper 2 in Verbindung steht. Unter Verwendung einer Ätzschutzmaske wird dann ein Teil der Metallschicht entfernt, so dass an jedem Temperatursensor 1 die mit den Elektroden 3, 4, 5, 6 zusammenhängenden Kontaktierungsflächen 10, 11, 12 und 13 zurückbleiben.

Die Halbleiterscheibe wird nun entlang der Ränder der einzelnen Temperatursensoren 1 eingeritzt, worauf die einzelnen Sensoren durch Zerbrechen der Halbleiterscheibe voneinander getrennt werden. Die einzelnen Sensoren werden nun einzeln auf jeweils einem Sockel befestigt, und mittels eines geeigneten Messgeräts wird der zwischen zwei Elektroden vorhandene Widerstandswert festgestellt. Da die Durchmesser der Elektroden, zwischen denen der Widerstandswert bestimmt wurde, und auch die Durchmesser der anderen Elektroden bekannt sind, sind wegen der oben beschriebenen Zusammenhänge zwischen dem Widerstandswert und den Elektroden-Kontaktdurchmessern auch die zwischen den anderen möglichen Elektrodenpaaren vorhandenen Widerstandswerte bekannt. Dies ermöglicht es, die äusseren Anschlüsse 14 und 15 mit den Kontaktierungsflächen der Elektroden zu verbinden, zwischen denen ein Widerstandswert vorhanden ist, der im gewünschten Genauigkeitsbereich liegt.

Wenn vorausgesetzt wird, dass der spezifische Widerstand des Halbleitermaterials auf der gesamten Fläche einer Halbleiterscheibe konstant ist, ist zur Herstellung von Temperatursensoren mit einem gewünschten Widerstandswert nur eine einmalige Messung eines Widerstandswertes zwischen zwei Elektroden auf einem Temperatursensor notwendig. Aus dieser einen Messung können dann die beiden Elektroden bestimmt werden, zwischen denen der gewünschte Widerstandswert vorhanden ist und mit denen die äusseren Anschlüsse 14 und 15 verbunden werden müssen. Die äusseren Anschlüsse 14 und 15 können dann auf allen Temperatursensoren, die aus der gleichen Halbleiterscheibe stammen, mit den gleichen zwei Elektroden verbunden werden.

Sollte der spezifische Widerstand des Halbleitermaterials auf der Fläche der Halbleiterscheibe nicht konstant sein, dann kann vor dem Anbringen der Anschlüsse 14 und 15 an jedem Temperatursensor 1 zunächst der Widerstandswert zwischen zwei Elektroden bestimmt werden, worauf dann unter Berücksichtigung des beschriebenen Zusammenhangs zwischen dem jeweiligen Widerstandswert zwischen zwei Elektroden und den Elektroden-Kontaktdurchmessern die beiden Elektroden für die Verbindung mit äusseren Anschlüssen 14 und 15 ausgewählt werden, zwischen denen der gewünschte Widerstandswert vorliegt.

Die gemäss der obigen Beschreibung hergestellten Temperatursensoren haben somit mit grosser Genauigkeit den gewünschten Widerstandswert. Die Halbleitervorrichtung kann natürlich ausser als Temperatursensor auch dort überall eingesetzt werden, wo es auf einen genauen Widerstandswert zwischen den Elektroden ankommt.

## Patentansprüche

1. Halbleitervorrichtung (1) mit einem Halbleiterkörper (2) und zwei am Halbleiterkörper (2) angebrachten Elektroden, die mit äusseren Anschlüssen (14, 15) verbunden sind, wobei der zwischen den Elektroden messbare Widerstand bei einer bestimmten Solltemperatur einem vorgegebenen Sollwert entspricht, dadurch gekennzeichnet, dass am Halbleiterkörper (2) mehr als zwei Elektroden (3, 4, 5, 6) mit unterschiedlichen Elektroden-Kontaktflächenabmessungen angebracht sind, von denen zwei entsprechend dem gewünschten Widerstandswert ausgewählte Elektroden (4, 6) mit den äusseren Anschlüssen (14, 15) verbunden sind und wobei die Dicke (D) des Halbleiterkörpers (2) gross ist gegen denjenigen Durchmesser ($d_3$ bis $d_6$), der zu einem den Elektroden-Kontaktflächen flächengleichen Kreis gehört.

2. Vorrichtung nach Anspruch 1, dadurch gekennzeichnet, dass die Elektroden (3, 4, 5, 6) auf derselben Fläche des Halbleiterkörpers (2) angebracht sind.

3. Vorrichtung nach Anspruch 2, dadurch gekennzeichnet, dass die Elektroden (3, 4, 5, 6) kreisförmig sind.

4. Vorrichtung nach einem der Ansprüche 1 bis 3, dadurch gekennzeichnet, dass auf einer Fläche des Halbleiterkörpers (2) eine Isolierschicht (7) angebracht ist, in der Fenster (8, 9) unterschiedlicher Grösse geöffnet sind, durch die die Elektroden (3, 4, 5, 6) mit dem Halbleiterkörper (2) in Verbindung stehen.

5. Vorrichtung nach Anspruch 4, dadurch gekennzeichnet, dass die Elektroden (3, 4, 5, 6) auf der Oberfläche der Isolierschicht (7) zur Bildung von Kontaktierungsflächen (10, 11, 12, 13) für die äusseren Anschlüsse (14, 15) erweitert sind.

6. Vorrichtung nach einem der Ansprüche 2 bis 5, dadurch gekennzeichnet, dass auf einer Fläche des Halbleiterkörpers (2) vier Elektroden (3, 4, 5, 6) angebracht sind.

7. Vorrichtung nach einem der Ansprüche 1 bis 6, gekennzeichnet durch ihre Verwendung als Temperatursensor.

8. Verfahren zur Herstellung einer Halbleitervorrichtung nach den vorhergehenden Ansprüchen, dadurch gekennzeichnet, dass auf einer Fläche eines Halbleiterkörpers (2) eine Isolierschicht (7) angebracht wird, dass in der Isolierschicht (7) mehr als zwei Fenster (8, 9) mit unterschiedlichen Durchmessern ($d_3$, $d_4$, $d_5$, $d_6$) gebildet werden, dass zur Bildung von Elektroden (3, 4, 5, 6) auf der Isolierschicht (7) und in den Fenstern (8, 9) eine Metallschicht abgeschieden wird, dass die Metallschicht derart teilweise entfernt wird, dass Elektroden (3, 4, 5, 6) in den Fenstern (8, 9) und damit zusammenhängende Kontaktierungsflächen (10, 11, 12, 13) für die äusseren Anschlüsse (14, 15) auf der Isolierschicht (7) zurückbleiben, die von den mit den anderen Elektroden (3, 4, 5, 6) zusammenhängenden Kontaktierungsflächen (10, 11, 12, 13) getrennt sind, dass der zwischen zwei vorbestimmten Elektroden (3, 4, 5, 6) vorhandene Widerstandswert gemessen wird, und dass abhängig vom Messergebnis die äusseren Anschlüsse (14, 15) mit den zwei Elektroden (4, 6) verbunden werden.

## Claims

1. Semiconductor device (1) comprising a semiconductor body (4) and two electrodes which are attached to the semiconductor body (2) and are connected to external terminals (14, 15) the measurable resistance between the electrodes corresponding to a predetermined desired value at a given desired temperature, characterized in that on the semiconductor body (2) more than two electrodes (3, 4, 5, 6) with different electrode contact area dimensions are disposed, of which two electrodes (4,6) selected according to the desired resistance value are connected to the external terminals (14, 15) and the thickness (D) of the semiconductor body (2) is great compared with the diameter ($d_3$ to $d_6$) of a circle which is equal in area to the electrode contact areas.

2. Device according to claim 1, characterized in that the electrodes (3, 4, 5, 6) are arranged on the same face of the semiconductor body (2).

3. Device according to claim 2, characterized in that the electrodes (3, 4, 5, 6) are circular.

4. Device according to any one of claims 1 to 3, characterized in that on the face of the semiconductor body (2) an insulating layer (7) is applied in which windows (8, 9) of various size are opened through which the electrodes (3, 4, 5, 6) are in connection with the semiconductor body (2).

5. Device according to claim 4, characterized in that the electrodes (3, 4, 5, 6) on the surface of the insulating layer (7) are extended for forming contacting faces (10, 11, 12, 13) for the external terminals (14, 15).

6. Device according to any one of claims 2 to 5, characterized in that on a face of the semiconductor body (2) four electrodes (3, 4, 5, 6) are disposed.

7. Device according to any one of claims 1 to 6, characterized by its use as temperature sensor.

8. Method of making a semiconductor device according to the preceding claims, characterized in that on a face of a semiconductor body (2) an insulating layer (7) is disposed, that in the insulating layer (7) more than two windows (8, 9) of different diameters ($d_3$, $d_4$, $d_5$, $d_6$) are formed, that to form electrodes (3, 4, 5, 6) on the insulating layer (7) and in the windows (8, 9) a metal layer is deposited, that the metal layer is partially removed in such a manner that electrodes (3, 4, 5, 6) in the windows (8, 9) and continuous therewith contacting faces (10, 11, 12, 13) for the external terminals (14, 15) remain on the insulating layer (7) which are separate from the contacting faces (10, 11, 12, 13) continuous with other electrodes (3, 4, 5, 6), that the resistance value between two predetermined electrodes (3, 4, 5, 6) is measured and that in dependence upon the result of the measurement the external terminals (14, 15) are connected with the two electrodes (4, 6).

## Revendications

1. Dispositif semi-conducteur (1) comprenant un corps de semi-conducteur (2) et deux électrodes fixées sur le còrps de semi-conducteur (2), qui sont reliées à des connexions extérieures (14, 15), et dans lequel la résistance qu'on peut mesurer entre les électrodes correspond à une valeur prescrite prédéterminée à une température prescrite déterminée, caractérisé en ce que, sur les corps de semi-conducteur (2), sont formées plus de deux électrodes (3, 4, 5, 6) présentant différentes dimensions de surfaces de contact d'électrodes, deux (4, 6) de ces électrodes sélectionnées d'après la valeur de résistance désirée, étant reliées aux connexions extérieures (14, 15), l'épaisseur (D) du corps de semi-conducteur (2) étant grande comparativement au diamètre ($d_3$ à $d_6$) qui appartient à un cercle de même surface que les faces de contact des électrodes.

2. Dispositif selon la revendication 1, caractérisé en ce que les électrodes (3, 4, 5, 6) sont formées sur la même face du corps de semi-conducteur (2).

3. Dispositif selon la revendication 2, caractérisé en ce que les électrodes (3, 4, 5, 6) sont circulaires.

4. Dispositif selon les revendications 1 à 3, caractérisé en ce que sur une face du corps de semi-conducteur (2), est formée une couche isolante (7) dans laquelle sont ouvertes des fenêtres (8, 9) de différentes dimensions à travers lesquelles les électrodes (3, 4, 5, 6) sont en liaison avec le corps de semi-conducteur (2).

5. Dispositif selon la revendication 4, caractérisé en ce que les électrodes (3, 4, 5, 6) se prolongent sur la surface de la couche isolante (4) pour former des surfaces de contact (10, 11, 12, 13) pour les connexions extérieures (14, 15).

6. Dispositif selon l'une des revendications 2 à 5, caractérisé en ce que, sur une face du corps de semi-conducteur (2) sont formées quatre électrodes (3, 4, 5, 6).

7. Dispositif selon l'une des revendications 1 à 6, caractérisé par son utilisation en qualtié de capteur de température.

8. Procédé de fabrication d'un dispositif à semi-conducteur selon les revendications précédentes, caractérisé en ce qu'on dépose une couche isolante (7) sur une face d'un corps de semi-conducteur (2) en ce qu'on forme dans la couche isolante (7) plus de deux fenêtres (8, 9) possédant diffé-rents diamètres ($d_3$, $d_4$, $d_5$, $d_6$), en ce que, pour former les électrodes (3, 4, 5, 6), on dépose une couche métallique sur la couche isolante (7) et dans les fenêtres (8, 9), en ce qu'on élimine partiellement la couche métallique de manière qu'il subsiste des électrodes (3, 4, 5, 6) dans les fenêtres (8, 9) ainsi que des surfaces de contact (10, 11, 12, 13) pour les connexions extérieures (14, 15), qui font corps avec les électrodes sur la couche isolante (7), ces surfaces étant isolées des surfaces de contact (10, 11, 12, 13) qui font corps avec les autres électrodes (3, 4, 5, 6), en ce qu'on mesure la valeur de résistance existant entre deux électrodes (3, 4, 5, 6) prédéterminées et en ce que, en fonction du résultat de la mesure, on relie les connexions extérieures (14, 15) aux deux électrodes (4, 6).

Fig. 1

Fig. 2